# EUROPEAN PATENT APPLICATION

(11) **EP 1 990 810 A1**
(43) Date of publication of application: **12.11.2008**
(21) Application number: 07713629.9
(22) Date of filing: 17.01.2007
(51) Int. Cl.: H01B 13/00, H01B 12/06, H01F 6/06

(54) **PROCESS FOR PRODUCING SUPERCONDUCTING THIN-FILM MATERIAL, SUPERCONDUCTING EQUIPMENT AND SUPERCONDUCTING THIN-FILM MATERIAL**

(30) Priority: 16.02.2006 JP 2006039396
(71) Applicant: Sumitomo Electric Industries, Ltd., Osaka-shi, Osaka 541-0041 (JP); International Superconductivity Technology Center, The Juridical Foundation, Shinbashi Minato-ku Tokyo 105-0004 (JP)
(72) Inventor: HAHAKURA, Shuji, Osaka-shi Osaka 554-0024 (JP); OHMATSU, Kazuya, Osaka-shi Osaka 554-0024 (JP); UEYAMA, Munetsugu, Osaka-shi Osaka 554-0024 (JP); HASEGAWA, Katsuya, Osaka-shi Osaka 554-0024 (JP)
(74) Representative: Desormiere, Pierre-Louis
(86) International application number: PCT/JP2007/050593
(87) International publication number: WO 2007/094147

(57) **Abstract**

A method of manufacturing a superconducting thin film material includes the step of forming an intermediate layer (2), the step of forming one superconducting layer (3) to be in contact with the intermediate layer (2) and the step of forming another superconducting layer (4) by a vapor phase method to be in contact with the one superconducting layer (3). Between the step of forming the intermediate layer (2) and the step of forming the one superconducting layer (3), the intermediate layer (2) is kept in a reduced water vapor ambient or reduced carbon dioxide ambient or, between the step of forming one superconducting layer (3) and the step of forming another superconducting layer (4), the one superconducting layer (3) is kept in a reduced water vapor ambient or reduced carbon dioxide ambient. Thus, the critical current value can be improved.

## Description

### TECHNICAL FIELD

The present invention relates to a method of manufacturing a superconducting thin film material, a superconducting device and a superconducting thin film material. More specifically, the invention relates to a method of manufacturing a superconducting thin film material having an RE123 composition, a superconducting device and a superconducting thin film material.

### BACKGROUND ART

Two types of superconducting wires: a superconducting wire using a bismuth-based superconductor and a superconducting wire using an RE123-based superconductor are now being particularly developed. Of these wires, the RE123-based superconducting wire has the advantage that the critical current density at the liquid nitrogen temperature (77.3 K) is higher than that of the bismuth-based superconducting wire. Additionally, it has the advantage of a high critical current value under a low temperature condition and under a constant magnetic field condition. Therefore, the RE123-based superconducting wire is expected as a next generation high-temperature superconducting wire.

Unlike the bismuth-based superconductor, the RE123-based superconductor cannot be covered with a silver sheath. Therefore, the RE123-based superconductor is manufactured by depositing a film of a superconductor (superconducting thin film material) on a textured metal substrate by a vapor phase method for example.

Japanese Patent Laying-Open No. 2003-323822 (Patent Document 1) for example discloses a method of manufacturing a conventional RE123-based superconducting thin film material. Patent Document 1 discloses the technique of forming an intermediate layer on a metal tape substrate using the pulsed laser deposition (PLD) method, forming a first superconducting layer having an RE123 composition on the intermediate layer using the pulsed laser deposition method, and forming a second superconducting layer having an RE123 composition on the first superconducting layer using the pulsed laser deposition method. The method of manufacturing the superconducting thin film material of Patent Document 1 can increase the film thickness of the superconducting thin film material by depositing multiple superconducting layers. Therefore, the cross-sectional area where current flows is increased and the critical current value of the superconducting wire can be increased.
Patent Document 1: Japanese Patent Laying-Open No. 2003-323822

### DISCLOSURE OF THE INVENTION

### PROBLEMS TO BE SOLVED BY THE INVENTION

The superconducting wire obtained using the conventional manufacturing method, however, has the following property. As the thickness of the superconducting thin film material increases, the critical current density decreases and the critical current value becomes gradually slow to increase. The resultant problem is therefore that the critical current value cannot be improved.

An object of the present invention is therefore to provide a method of manufacturing a superconducting thin film material, a superconducting device and a superconducting thin film material for which the critical current value can be improved.

### MEANS FOR SOLVING THE PROBLEMS

According to an aspect of the present invention, a method of manufacturing a superconducting thin film material includes an underlying layer step of forming an underlying layer and a superconducting layer step of forming a superconducting layer by a vapor phase method such that the superconducting layer is in contact with the underlying layer. Between the underlying layer step and the superconducting layer step, the underlying layer is kept in a reduced water vapor ambient or reduced carbon dioxide ambient.

According to another aspect of the present invention, a method of manufacturing a superconducting thin film material includes an underlying layer step of forming an underlying layer and a superconducting layer step of forming a superconducting layer by a vapor phase method such that the superconducting layer is in contact with the underlying layer. Between the underlying layer step and the superconducting layer step, the underlying layer is kept without exposed to atmosphere.

The inventors of the present application found that the moisture in the atmosphere and any impurity such as carbon dioxide in the atmosphere attach to the underlying layer of the superconducting layer to deteriorate the quality of the superconducting layer, which is a cause of hindrance to increase of the critical current value. The method of manufacturing the superconducting thin film material in Patent Document 1 removes the metal tape substrate from the vacuum chamber for replacing the windings of the wire for example and leaves the metal tape substrate in the atmosphere between the formation of the intermediate layer and the formation of the first superconducting layer and between the formation of the first superconducting layer and the formation of the second superconducting layer. Therefore, the moisture and any impurities such as carbon dioxide in the atmosphere attach to the underlying layer (such as intermediate layer and underlying superconducting layer) of the superconducting layer. The impurities react with the superconducting layer to deteriorate the superconducting property of the superconducting thin film material, resulting in decrease of the critical current value.

Accordingly, the method of manufacturing the superconducting thin film material of the present invention keeps the underlying layer in the reduced water vapor ambient or reduced carbon dioxide ambient, or keeps the underlying layer without exposing it to the atmosphere between the underlying layer step and the superconducting layer step. Therefore, the moisture or carbon dioxide in the atmosphere can be prevented from attaching to the underlying layer of the superconducting layer. As a result, deterioration of the superconducting property of the superconducting thin film material can be prevented and the critical current value can be improved while increasing the thickness of the superconducting thin film material.

Here, "reduced water vapor ambient" refers to an ambient containing moisture equal to or lower than a moisture content of the atmosphere dried at a room temperature (20 to 25°C). Namely, the reduced water vapor ambient refers to a water vapor ambient having a moisture content lower than that of the atmosphere having a humidity of 10% at the room temperature, and specifically corresponds to, for example, an ambient having a pressure lower than the atmospheric pressure or an ambient filled with an inert gas such as nitrogen or argon. Further, "reduced carbon dioxide ambient" refers to an ambient having a carbon dioxide content lower than that of the air. The reduced water vapor ambient and the reduced carbon dioxide ambient include, in addition to the ambient having a pressure lower than the atmospheric pressure (reduced pressure ambient), an ambient filled with a noble gas such as nitrogen.

Preferably, according to the method of manufacturing the superconducting thin film material of the present invention, an underlying superconducting layer is formed as the underlying layer in the underlying layer step.

Accordingly, any impurity is less prone to attach to the surface of the underlying superconducting layer. Therefore, in the case where multiple superconducting layers are deposited to form a superconducting layer of a large thickness, deterioration of the superconducting property of the superconducting layer formed on the underlying superconducting layer can be prevented.

Preferably, according to the method of manufacturing the superconducting thin film material of the present invention, an intermediate layer is formed as the underlying layer in the underlying layer step.

Accordingly, any impurity is less prone to attach to the surface of the intermediate layer. Therefore, deterioration of the superconducting property of the superconducting layer formed on the intermediate layer can be prevented.

Preferably, according to the method of manufacturing the superconducting thin film material of the present invention, an underlying layer is formed on a substrate in the underlying layer step. The substrate is made of a metal, the underlying layer is made of an oxide having a crystal structure of any of rock type, perovskite type and pyrochlore type, and the superconducting layer has an RE123 composition.

In this way, the superconducting thin film material excellent in crystal orientation and surface smoothness can be obtained and the critical current density and the critical current value can be improved.

Preferably, according to the method of manufacturing the superconducting thin film material of the present invention, in the underlying layer step, the underlying layer is formed on a tape-shaped substrate, and the underlying layer is formed while a position where the underlying layer is formed at the substrate is shifted in one direction along longitudinal direction of the substrate. In the superconducting layer step, the superconducting layer is formed while a position where the superconducting layer is formed at the underlying layer is shifted in a direction opposite to the aforementioned one direction.

Accordingly, the underlying layer and the superconducting layer can be successively formed without replacing the windings of the wire for example. Therefore, between the underlying layer step and the superconducting layer step, the underlying layer can be easily kept in the reduced pressure ambient.

Regarding the method of manufacturing the superconducting thin film material of the present invention, preferably the vapor phase method is any of laser deposition method, sputtering method and electron beam evaporation method.

In this way, the superconducting thin film material excellent in crystal orientation and surface smoothness can be obtained and the critical current density and the critical current value can be improved.

A superconducting device according to the present invention uses a superconducting thin film material manufactured by the method of manufacturing a superconducting thin film material as described above.

With the superconducting device of the present invention, the critical current density and the critical current value can be improved.

A superconducting device of the present invention is preferably a superconducting device using a superconducting thin film material including a first superconducting layer, a second superconducting layer formed to be in contact with the first superconducting layer and a third superconducting layer formed to be in contact with the second superconducting layer, and having a critical current value larger than 70 (A/cm-width).

It should be noted that "RE123" herein refers to REₓBa_{y}CU_{z}O_{7-d} where 0.7 ≤ x ≤ 1.3, 1.7 ≤ y ≤ 2.3, 2.7 ≤ z ≤ 3.3. RE of "RE123" refers to a material including at least any of a rare earth element and an yttrium element. The rare earth element includes for example neodymium (Nd), gadolinium (Gd), holmium (Ho) and samarium (Sm).

### EFFECTS OF THE INVENTION

With a method of manufacturing a superconducting thin film material, a superconducting device and a superconducting thin film material of the present invention, the critical current value can be improved.

### BRIEF DESCRIPTION OF THE DRAWINGS

Fig. 1 is a partial cross-sectional perspective view schematically showing a structure of a superconducting thin film material in an embodiment of the present invention.
Fig. 2 is a flowchart showing a method of manufacturing a superconducting thin film material in an embodiment of the present invention.
Fig. 3 schematically shows a manner of forming an intermediate layer by successive deposition in an embodiment of the present invention.
Fig. 4 schematically shows a manner of forming a superconducting layer by successive deposition in an embodiment of the present invention.
Fig. 5 schematically shows a manner of forming a layer by fixed deposition in an embodiment of the present invention.
Fig. 6 shows a relation between the thickness and the critical current value of a superconducting layer in Example 1 of the present invention.
Fig. 7 is a partial cross-sectional perspective view schematically showing another structure of the superconducting thin film material in an embodiment of the present invention.

### DESCRIPTION OF THE REFERENCE SIGNS

1 metal substrate, 2 intermediate layer, 3-5 superconducting layer, 10 superconducting thin film material, 11, 12 rotational shaft, 13 vapor deposition source, 14 platform, 20 chamber

### BEST MODES FOR CARRYING OUT THE INVENTION

In the following, an embodiment of the present invention will be described based on the drawings.

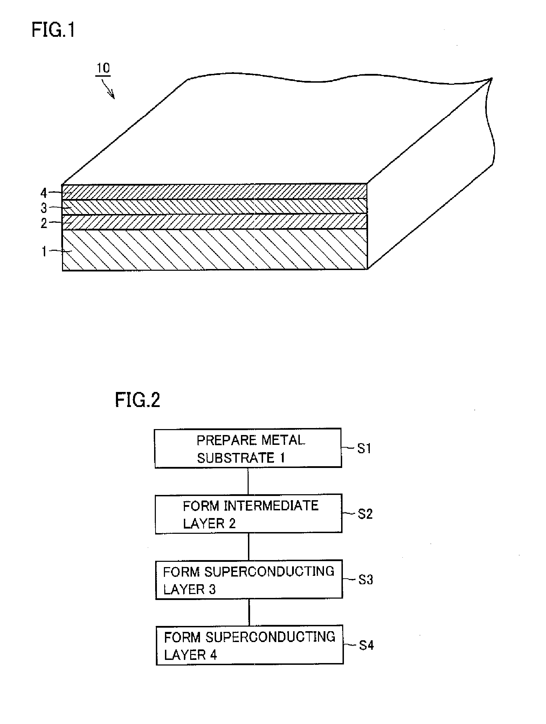

Fig. 1 is a partial cross-sectional perspective view schematically showing a structure of a superconducting thin film material in an embodiment of the present invention. Referring to Fig. 1, superconducting thin film material 10 in the present embodiment is tape-shaped, and includes a metal substrate 1, an intermediate layer 2, a superconducting layer 3, and a superconducting layer 4. Superconducting thin film material 10 is used for such devices as superconducting device for example.

Metal substrate 1 is made of a metal such as stainless, nickel alloy (Hastelloy for example) or silver alloy for example.

Intermediate layer 2 is formed on metal substrate 1 and functions as a diffusion preventing layer. Intermediate layer 2 is made of an oxide having a crystal structure which is any of rock type, perovskite type and pyrochlore type for example. Specifically, intermediate layer 2 is made of a material such as ceric oxide, yttria stabilized zirconia (YSZ), magnesium oxide, yttrium oxide, ytterbium oxide or barium zirconia, for example.

Superconducting layer 3 and superconducting layer 4 are layered on intermediate layer 2. Superconducting layer 3 and superconducting layer 4 are made of substantially the same material and have an RE123 composition for example.

Although the structure including intermediate layer 2 is described in connection with Fig. 1, intermediate layer 2 may not be included.

A method of manufacturing a superconducting thin film material in the present embodiment will now be described.

Fig. 2 is a flowchart showing the method of manufacturing the superconducting thin film material in an embodiment of the present invention. Referring to Figs. 1 and 2, according to the method of manufacturing the superconducting thin film material in the present embodiment, metal substrate 1 is prepared first (step S1). Then, intermediate layer 2 made of YSZ for example is formed on metal substrate 1 by the laser deposition method (step S2). In the case where metal substrate 1 is tape-shaped, intermediate layer 2 is formed for example by the successive deposition as described below.

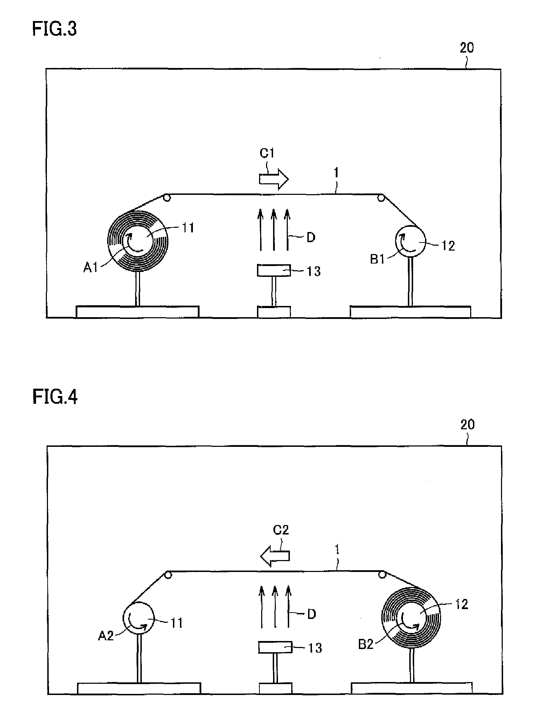

Fig. 3 schematically shows a manner of forming the intermediate layer by the successive deposition in an embodiment of the present invention. Referring to Fig. 3, tape-shaped metal substrate 1 is wound on a rotational shaft 11 disposed in a chamber 20. One end of metal substrate 1 is extended from rotational shaft 11 and fixed at a rotational shaft 12. Then, a reduced pressure ambient is generated in chamber 20, and rotational shafts 11 and 12 are rotated in respective directions of arrows A1 and B1. Accordingly, metal substrate 1 is fed in the direction of arrow C1, and metal substrate I having been wound on rotational shaft 11 is then wound up on rotational shaft 12. While metal substrate 1 is fed in the direction or arrow C1, atoms to be components of intermediate layer 2 are ejected from a vapor deposition source 13 in the direction of arrow D to form intermediate layer 2 on metal substrate 1. Namely, intermediate layer 2 is formed in a process in which the position where intermediate layer 2 is formed at metal substrate 1 is shifted in the longitudinal direction of metal substrate 1 (the direction from one end fixed to rotational shaft 12 toward the other end fixed at rotational shaft 11). When the formation of intermediate layer 2 is completed, the whole metal substrate 1 is wound up on rotational shaft 12.

Referring to Figs. 1 and 2, after intermediate layer 2 is formed, the reduced pressure ambient of the inside of chamber 20 is still maintained. Then, superconducting layer 3 having an RE123 composition for example is formed by a vapor phase method such that superconducting layer 3 is in contact with intermediate layer 2 which is an underlying layer (step S3). As the vapor phase method for forming superconducting layer 3, the laser deposition method, sputtering method or electron beam evaporation method for example is used. Superconducting layer 3 is formed by the successive deposition as described below for example.

Fig. 4 schematically shows a manner of forming a superconducting layer using the successive deposition in an embodiment of the present invention. Referring to Fig. 3, the whole metal substrate 1 is wound on rotational shaft 12, and the other end of metal substrate 1 is extended and fixed at rotational shaft 11. Then, rotational shafts 11 and 12 are rotated in respective directions of arrows A1 and B2. Accordingly, metal substrate 1 is fed in the direction of arrow C2, and metal substrate 1 having been wound on rotational shaft 12 is then wound up on rotational shaft 11. While metal substrate 1 is fed in the direction of arrow C2, atoms to be components of superconducting layer 3 are ejected from vapor deposition source 13 in the direction of arrow D to form superconducting layer 3 on intermediate layer 2. Namely, intermediate layer 2 is formed in a process in which the position where superconducting layer 3 is formed at metal substrate 1 is shifted in the longitudinal direction of metal substrate 1 (the direction from the end fixed to rotational shaft 11 toward the end fixed at rotational shaft 12). When the formation of superconducting layer 3 is completed, the whole metal substrate 1 is wound up on rotational shaft 11.

Referring to Figs. 1 and 2, after superconducting layer 3 is formed, the reduced pressure ambient in chamber 20 is still maintained. Then, superconducting layer 4 having an RE 123 composition for example is formed by a vapor phase method such that superconducting layer 4 is in contact with superconducting layer 3 which is the underlying superconducting layer (step S4). As the vapor phase method for forming superconducting layer 4, the laser deposition method, sputtering method or electron beam evaporation method for example is used. Superconducting layer 4 is formed by the same method as that for forming intermediate layer 2 shown for example in Fig. 3 (while metal substrate 1 is fed in the direction of arrow C1).

In this way, while metal substrate 1 is wound up on rotational shafts 11 and 12 by turns, intermediate layer 2, superconducting layer 3 and superconducting layer 4 are each formed on each other. Thus, without the need to remove metal substrate 1 from chamber 20, these layers can be formed in the reduced pressure ambient. Through the above-described process steps, superconducting thin film material 10 is completed.

In the case where intermediate layer 2 is not formed, the above-described step of forming intermediate layer 2 (step S2) is not performed and, in the step of forming superconducting layer 3 (step S3), superconducting layer 3 is formed such that superconducting layer 3 is in contact with metal substrate 1.

Referring to Fig. 3, in the conventional case where intermediate layer 2 and superconducting layer 3 are successively deposited, metal substrate 1 is fed only in the direction of arrow C1. Namely, in the conventional case, while metal substrate 1 is fed in the direction of arrow C1, one layer is vapor-deposited and, when the vapor deposition is completed, rotational shaft 12 on which metal substrate 1 is wound up and metal substrate 11 are replaced with each other. Then, while metal substrate 1 is fed again in the direction of arrow C1, the subsequent layer is vapor-deposited. Since metal substrate 1 is removed from chamber 20 for replacing the windings of the wire with each other (replacing the rotational shafts with each other), the moisture and any impurity such as carbon dioxide in the atmosphere attach to the surface of intermediate layer 2 and that of superconducting layer 3.

The method of manufacturing the superconducting thin film material in the present embodiment keeps intermediate layer 2 in the reduced pressure ambient between the formation of intermediate layer 2 and the formation of superconducting layer 3. Therefore, any impurity in the atmosphere can be prevented from attaching to intermediate layer 2. Similarly, between the formation of superconducting layer 3 and the formation of superconducting layer 4, superconducting layer 3 is kept in the reduced pressure ambient. Therefore, any impurity in the atmosphere can be prevented from attaching to superconducting layer 3. As a result, deterioration of the superconducting property of superconducting layers 3 and 4 each can be prevented, and the critical current value can be improved while the film thickness of the superconducting thin film material is increased.

Since intermediate layer 2 made of an oxide having a crystal structure that is any of rock type, perovskite type and pyrochlore type is formed on metal substrate 1 and superconducting layer 3 and superconducting layer 4 both have an RE 123 composition the superconducting thin film material excellent in surface smoothness and compactness of the crystal can be obtained and the critical current density and the critical current value can be improved.

Further, since the vapor phase method is any of the laser deposition method, sputtering method and electron beam evaporation method, the superconducting thin film material excellent in surface smoothness and compactness of the crystal can be obtained and the critical current density and the critical current value can be improved.

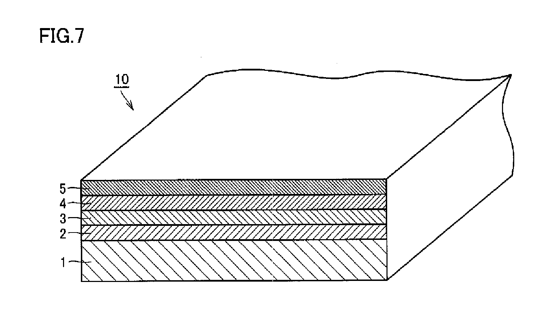

While the present embodiment shows the case where the two layers that are superconducting layer 3 (first superconducting layer) and superconducting layer 4 (second superconducting layer) are formed, a superconducting layer 5 (third superconducting layer) may further be formed on superconducting layer 4 as shown in Fig. 7. A large number of superconducting layers can be formed on each other to increase the film thickness of the superconducting thin film material.

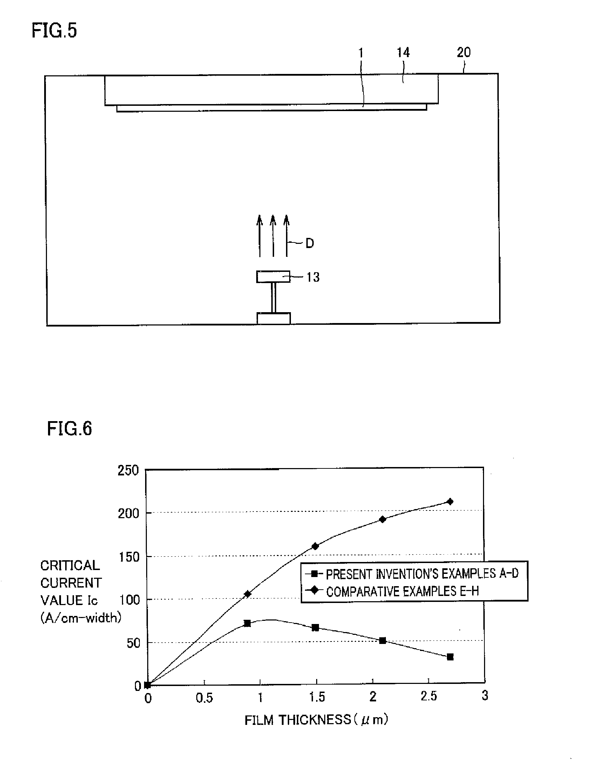

Further, the present embodiment shows the case where intermediate layer 2, superconducting layer 3 and superconducting layer 4 are formed in the reduced pressure ambient by the successive deposition. Alternatively, the present invention may form intermediate layer 2, superconducting layer 3 and superconducting layer 4 each by the fixed deposition fixing metal substrate 1 to a platform 14 and fixing vapor deposition source 13 to chamber 20 as shown in Fig. 5 for example. In other words, the condition to be satisfied is that, between the formation of the underlying layer and the formation of the superconducting layer, the underlying layer is kept in the reduced water vapor ambient or reduced carbon dioxide ambient or kept without being exposed to the atmosphere.

### Example 1

In the present example, respective superconducting thin film materials of Present Invention's Examples A to D and Comparative Examples E to H were manufactured and the critical current value thereof was measured.

As to Present Invention's Examples A to D, on an Ni alloy substrate, an intermediate layer made of a metal-based oxide was deposited using a vapor phase deposition method. Subsequently, the laser deposition method was used to deposit multiple superconducting layers made of HoBa₂Cu₃Oₓ (HoBCO) on the intermediate layer. Each superconducting layer had a thickness of 0.3 µm, and the number of deposited superconducting layers was changed so that three superconducting layers, five superconducting layers, seven superconducting layers and nine superconducting layers were formed, thereby changing the total thickness of the superconducting layers. The superconducting layers were formed by the successive deposition and, between one formation step and the subsequent formation step for the intermediate layer and the superconducting layers, the sample was kept in the reduced pressure ambient without exposed to the atmosphere.

As to Comparative Examples E to H, on an Ni alloy substrate, an intermediate layer made of a metal-based oxide was deposited using a vapor phase deposition method. Subsequently, the laser deposition method was used to deposit multiple superconducting layers made of HoBa₂Cu₃Oₓ (HoBCO) on the intermediate layer. Each superconducting layer had a thickness of 0.3 µm, and the number of deposited superconducting layers was changed so that three superconducting layers, five superconducting layers, seven superconducting layers and nine superconducting layers were formed, thereby changing the total thickness of the superconducting layers. The superconducting layers were formed by the successive deposition and, between one formation step and the subsequent formation step for the intermediate layer and the superconducting layers, the sample was exposed to the atmosphere.

The critical current value per cm width measured for each of Present Invention's Examples A to D and Comparative Examples E to H is shown in Table 1 and Fig. 6.

**Table 1**

| Sample | Present Invention's Example A | Present Invention's Example B | Present Invention's Example C | Present Invention's Example D | Comparative Example E | Comparative Example F | Comparative Example G | Comparative Example H |
|---|---|---|---|---|---|---|---|---|
| State where Sample is Kept between Layer Formation Steps | Not Exposed to Atmosphere (Reduced Pressure Ambient) | | | | Exposed to Atmosphere | | | |
| Total Thickness of Superconducting Layers (µm) | 0.9 (3 layers) | 1.5 (5 layers) | 2.1 (7 layers) | 2.7 (9 layers) | 0.9 (3 layers) | 1.5 (5 layers) | 2.1 (7 layers) | 2.7 (9 layers) |
| Critical Current Value (A/cm-width) | 105 | 160 | 190 | 210 | 70 | 65 | 50 | 30 |

Referring to Table 1 and Fig. 6, regarding Present Invention's Examples A to D, the critical current value increases as the film thickness of the superconducting layers increases. In contrast, regarding Comparative Examples E to H, the critical current value decreases as the film thickness of the superconducting layers increases. It is seen from this that the critical current value can be improved while the thickness of the superconducting layers is increased, by keeping the sample in the reduced pressure ambient between one deposition step and the subsequent deposition step for the intermediate layer and superconducting layers.

It should be construed that embodiments disclosed above are by way of illustration in all respects, not by way of limitation. It is intended that the scope of the present invention is defined by claims, not by the embodiments and examples above, and includes all modifications and variations equivalent in meaning and scope to the claims.

### INDUSTRIAL APPLICABILITY

The present invention is appropriate for a superconducting device including, for example, superconducting fault current limiter, magnetic field generating device, superconducting cable, superconducting busbar and superconducting coil and the like.

## Claims

1. A method of manufacturing a superconducting thin film material (10), comprising:
an underlying layer step of forming an underlying layer (2, 3); and
a superconducting layer step of forming a superconducting layer (4) by a vapor phase method such that the superconducting layer is in contact with said underlying layer, wherein
between said underlying layer step and said superconducting layer step, said underlying layer is kept in a reduced water vapor ambient or reduced carbon dioxide ambient.

2. The method of manufacturing the superconducting thin film material (10) according to claim 1, wherein
in said underlying layer step, an underlying superconducting layer (3) is formed as said underlying layer.

3. The method of manufacturing the superconducting thin film material (10) according to claim 1, wherein
in said underlying layer step, said underlying layer (2, 3) is formed on a tape-shaped substrate (1), and said underlying layer is formed while a position where said underlying layer is formed at said substrate is shifted in one direction (C1) along longitudinal direction of said substrate, and
in said superconducting layer step, said superconducting layer (4) is formed while a position where said superconducting layer is formed at said underlying layer is shifted in a direction (C2) opposite to said one direction.

4. A superconducting device using a superconducting thin film material (10) manufactured by the method of manufacturing a superconducting thin film material as recited in claim 1.

5. A method of manufacturing a superconducting thin film material (10), comprising:
an underlying layer step of forming an underlying layer (2, 3); and
a superconducting layer step of forming a superconducting layer (4) by a vapor phase method such that the superconducting layer is in contact with said underlying layer,
between said underlying layer step and said superconducting layer step, said underlying layer is kept without exposed to atmosphere.

6. The method of manufacturing the superconducting thin film material (10) according to claim 5, wherein
in said underlying layer step, an underlying superconducting layer (3) is formed as said underlying layer.

7. The method of manufacturing the superconducting thin film material (10) according to claim 5, wherein
in said underlying layer step, said underlying layer (2, 3) is formed on a tape-shaped substrate (1), and said underlying layer is formed while a position where said underlying layer is formed at said substrate is shifted in one direction (C1) along longitudinal direction of said substrate, and
in said superconducting layer step, said superconducting layer (4) is formed while a position where said superconducting layer is formed at said underlying layer is shifted in a direction (C2) opposite to said one direction.

8. A superconducting device using a superconducting thin film material (10) manufactured by the method of manufacturing a superconducting thin film material as recited in claim 5.

9. A superconducting thin film material (10) comprising a first superconducting layer (3), a second superconducting layer (4) formed to be in contact with said first superconducting layer and a third superconducting layer (5) formed to be in contact with said second superconducting layer, and having a critical current value larger than 70 (A/cm-width).
